# EUROPÄISCHE PATENTSCHRIFT

(11) **EP 1 297 605 B1**
(45) Veröffentlichungstag und Bekanntmachung des Hinweises auf die Patenterteilung: **01.06.2005**
(21) Anmeldenummer: 01943125.3
(22) Anmeldetag: 23.05.2001
(51) Int. Cl.: H02K 1/18, H02K 3/52, H02K 5/128

(54) **STATOR**
STATOR
STATOR

(30) Priorität: 25.05.2000 DE 10026003
(43) Veröffentlichungstag der Anmeldung: 02.04.2003
(73) Patentinhaber: ROBERT BOSCH GMBH, 70442 Stuttgart (DE)
(72) Erfinder: EGGERS, Wolf-Joachim, 76131 Karlsruhe (DE); PFETZER, Johannes, 77815 Buehl (DE); RIEHL, Guenther, 77815 Buehl (DE); SCHMITZ, Matthias, 38518 Gifhorn (DE)
(86) Internationale Anmeldenummer: PCT/DE2001/001933
(87) Internationale Veröffentlichungsnummer: WO 2001/091266

(56) Entgegenhaltungen:
- EP-A- 0 952 658
- DE-A- 3 905 997
- GB-A- 966 156
- US-A- 3 827 141
- US-A- 4 689 023
- PATENT ABSTRACTS OF JAPAN vol. 008, no. 226 (E-272), 17. Oktober 1984 (1984-10-17) & JP 59 106847 A (MITSUBISHI DENKI KK), 20. Juni 1984 (1984-06-20)

## Beschreibung

Die Erfindung geht aus von einem Stator nach der Gattung des Anspruchs 1.

Aus der US 3,827,141 ist ein Stator bekannt, bestehend aus zumindest einem Blechlaminatstapel, der aus zumindest einem Blechlaminat besteht, und einer zumindest teilweise vorhandenen Kunststoffbeschichtung, wobei der Stator zumindest einen Kernring hat, der einen wasserdichten Innenkanal bildet und sich entlang einer Mittelachse erstreckt, wobei auf den Kernring zumindest ein Blechlaminatstapel angeordnet ist und wobei der zumindest eine Blechlaminatstapel durch die Kunststoffbeschichtung zusammengehalten ist.

Aus der GB 966 156 A ist ein Stator bekannt, bestehend aus zumindest einem Blechlaminatstapel, der aus zumindest einem Blechlaminat besteht, und einer zumindest teilweise vorhandenen Kunststoffbeschichtung, wobei der Stator zumindest einen Kernring hat, der einen wasserdichten Innenkanal bildet und sich entlang einer Mittelachse erstreckt, wobei auf den Kernring zumindest ein Blechlaminatstapel angeordnet.

Aus der EP 0 952 658 A ist ein Stator bekannt, bestehend aus zumindest einem Blechlaminatstapel, der aus zumindest einem Blechlaminat besteht, und einer zumindest teilweise vorhandenen Kunststoffbeschichtung, wobei der Stator zumindest einen Kernring hat, der einen wasserdichten Innenkanal bildet und sich entlang einer Mittelachse erstreckt.

Aus der US 4,689,023 ist ein Stator bekannt, bestehend aus zumindest einem Blechlaminatstapel, der aus zumindest einem Blechlaminat besteht.

Aus der EP 0 880 215 A2 ist schon ein Stator bekannt, der eine Kunststoffbeschichtung hat. Die Kunststoffbeschichtung wird durch Kunststoffspritzen aufgebracht und gleichzeitig können auch Aufnahmen geformt werden, die das Montieren von einem Lager oder einem Stecker vereinfachen. Die einzelnen Blechlaminate des Stators müssen jedoch vor dem Kunststoffspritzen zu einem Blechpaket zusammengefügt werden. Beim Kunststoffumspritzen müssen weiterhin die Blechlaminate an den jeweiligen Statorpolzähnen zusammengedrückt werden, damit keine Lücke zwischen einzelnen Blechlaminaten entsteht, in die Kunststoff gelangen kann. Außerdem sind Statorpolzähne magnetisch leitend miteinander verbunden.

### Vorteile der Erfindung

Der erfindungsgemäße Stator mit den kennzeichnenden Merkmalen des Anspruchs 1 hat demgegenüber den Vorteil, dass auf einfache Art und Weise die Herstellung eines Stators erleichtert wird, wodurch sich der Stator eines elektrischen Motors einfacher, schneller und günstiger zusammenbauen lässt. Hierbei ist es für die Montage der Blechlaminatstapel auf den Kernring vorteilhaft, dass der Kernring für jeden Blechlaminatstapel einen hakenförmigen Vorsprung hat, der den Blechlaminatstapel zumindest teilweise umgreift und einen Formschluss bildet.

Durch die in den abhängigen Ansprüchen aufgeführten Maßnahmen sind vorteilhafte Weiterbildungen und Verbesserungen des im Anspruch 1 genannten Stators möglich.

Für die Montage der Blechlaminatstapel auf den Kernring ist es vorteilhaft, dass der Kernring eine Erhebung hat, die eine Nut des Blechlaminatstapels einführbar ist, weil dadurch der Blechlaminatstapel zentriert aufnehmbar ist.

Es ist vorteilhaft, die Kunststoffbeschichtung des Stators durch Kunststoffspritzen herzustellen.

Für das Aufbringen von Spulen auf das zumindest eine Blechlaminat ist es vorteilhaft, dass das Blechlaminat radial sich nach außen erstreckende Vorsprünge hat.

Eine vorteilhafte Ausbildung der Erfindung ist dadurch gegeben, dass um die Vorsprünge der Blechlaminate ein Spulenkörper angespritzt ist, weil dadurch das Montieren von Spulen auf dem Stator vereinfacht wird.

Für die Aufwicklung einer Spule auf den Spulenkörper ist es vorteilhaft, wenn die Kunststoffbeschichtung wenigstens einen Wickelstützpunkt hat, welcher das Erfassen des Stators vereinfacht und wenn eine unterste Wickelebene des Spulenkörpers den Spulenkörper nur berührt, weil dadurch der Spulenkörper zum Wickeln frei zugänglich ist und ein Wickelkopf einer Wicklungsmaschine frei um den Spulenkörper kreisen kann.

Wenn der Spulenkörper oder die Kunststoffbeschichtung weiterhin eine Aufnahme hat, kann in vorteilhafter Weise eine Schneid-, Klemmverbindung mit einem Spulendraht und äusseren Anschlüssen hergestellt werden.

Die Bildung eines Blechpakets aus Blechlaminat kann weiterhin vorteilhaft sein.

### Zeichnung

Ausführungsbeispiele der Erfindung sind in der Zeichnung vereinfacht dargestellt und in der nachfolgenden Beschreibung näher erläutert.

Es zeigen
Figur 1 einen Kernring,
Figur 2 einen Kernring mit Blechlaminaten,
Figur 3 Blechlaminate mit Kunststoffbeschichtung und Spulenkörper,
Figur 4 einen erfindungsgemässen Stator,
Figur 5 einen erfindungsgemässen Stator mit Stanzgitter, und
Figur 6 eine teilweise Darstellung einer Anordnung von einem Aussenteil an einem Vorsprung des Blechlaminats.

### Beschreibung der Ausführungsbeispiele

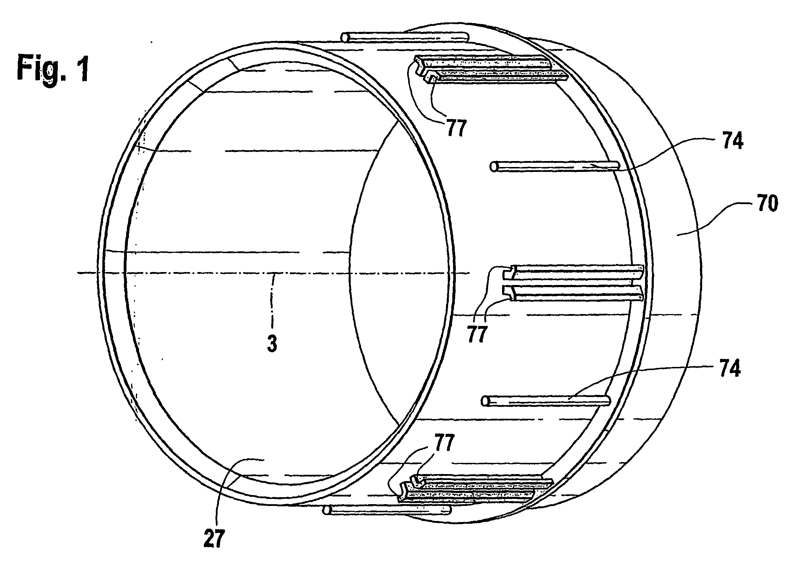

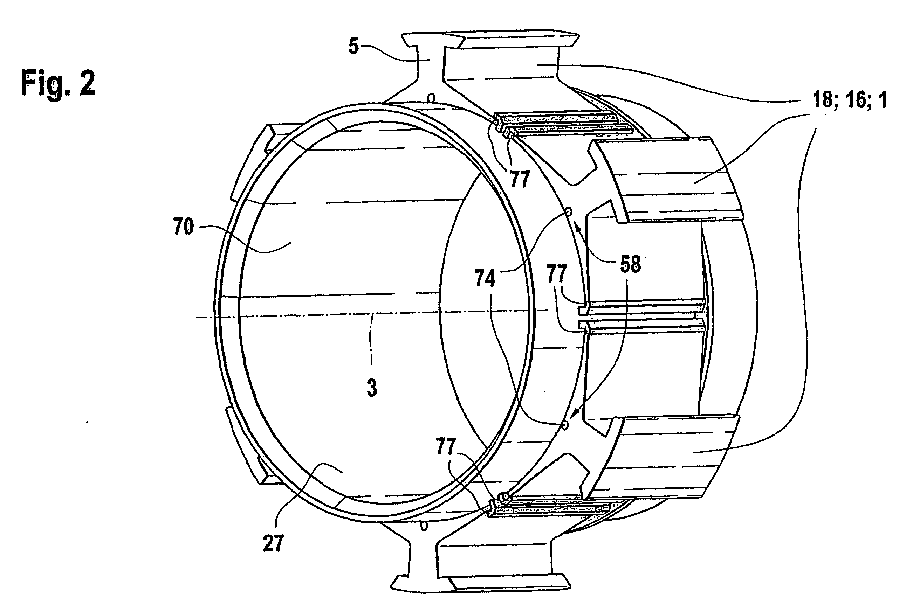

Figur 1 zeigt eine Kernring 70. Der Kernring 70 hat für jeden Blechlaminatstapel 16 (Fig. 2) zumindest einen hakenkörmigen Vorsprung 77, der auf einer Aussenfläche des Kernrings 70 in Richtung einer Mittelachse 3 verläuft. Der Vorsprung 77 umgreift einen Fuß eines Blechlaminatstapels 16 zumindest teilweise und bildet einen Formschluss. In diesem Beispiel gibt es zwei Vorsprünge 77 für je einen Blechlaminatstapel 16.
Zwischen diesen zwei Vorsprüngen hat der Kernring 70 zumindest eine Erhebung 74, die auf der Aussenfläche des Kernrings 70 in Richtung der Mittelachse 3 verläuft, und in die eine Nut 58 des Blechlaminatstapels 16 eingreift.
Der Kernring bildet einen wasserdichten Innenkanal 27, durch den ein Medium, z. B.ein flüssiges Medium gefördert werden kann.

Figur 2 zeigt Blechlaminate 1 in Form des Blechlaminatstapels 16 oder eines Blechlaminats 18, die auf dem Kernring 70 angeordnet sind. Für gleiche oder gleich wirkende Teile werden in den folgenden Figuren die gleichen Bezugszeichen wie in den vorherigen Figuren verwendet. Die Vorsprünge 77 und der Blechlaminatstapel 16 sind so zueinander ausgeformt, bspw. haben die Vorsprünge 77 radial unterschiedliche Höhen, so dass die Blechlaminate nur in einer bestimmten Art und Weise montiert werden können. Nach dem Aufbringen einer Kunststoffbeschichtung 22, beispielsweise durch Kunststoffspritzen wird der Blechlaminatstapel 16 durch diese teilweise vorhandene Kunststoffbeschichtung 22 zusammengehalten.

Ein so hergestelltes Bauteil ist beispielsweise ein Stator für eine Flüssigkeitspumpe, wobei die Vorsprünge 5 Statorpolzähne bilden.
Geringere elektrische Verluste während des Betriebs einer Pumpe entstehen dadurch, dass die Statorpolzähne getrennt magnetisch leitend voneinander ausgebildet sind.

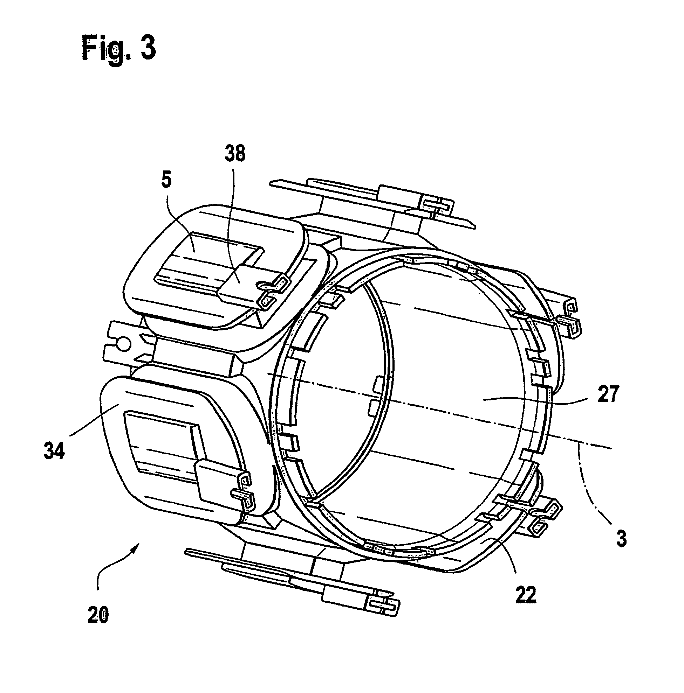

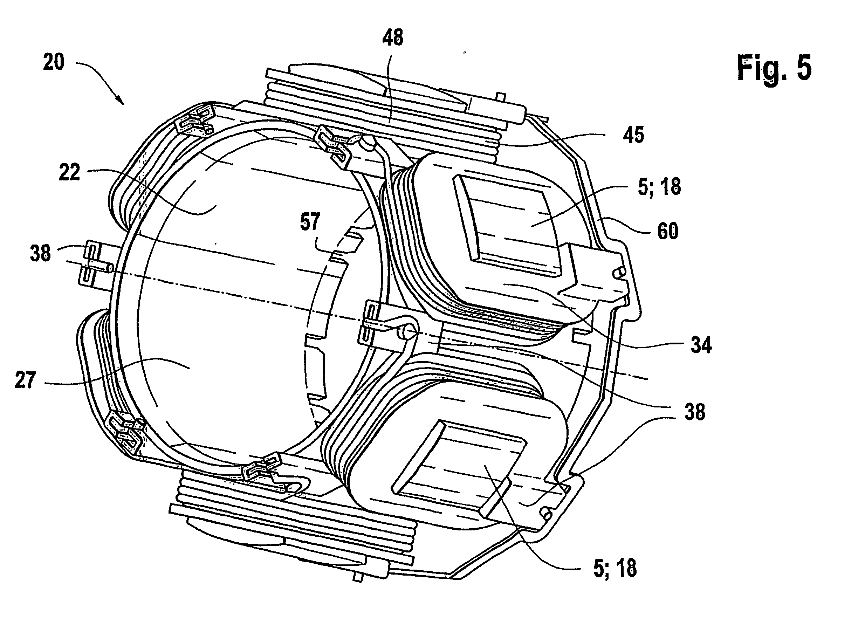

Figur 3 zeigt eine Weiterbildung eines Blechpakets 18 , mit Kunststoffbeschichtung 22 aus Figur 2.
Um die Vorsprünge 5, die Statorpolzähne bilden, ist ein Spulenkörper 34 angespritzt worden. Diese können in einem Arbeitsgang mit der Aufbringung der Kunststoffbeschichtung 22 hergestellt werden. Auf den Spulenkörper 34 kann eine Spule 45 (Fig. 5) aus elektrisch leitendem Draht aufgewickelt werden. Diese Spule 45 umschliesst den Vorsprung 5 und dient zur magnetischen Erregung eines nicht dargestellten Rotors. Zur äusseren elektrischen Stromversorgung der Spule 45 muss eine Verbindung hergestellt werden. Dies geschieht beispielsweise durch eine Aufnahme 38, in der eine Schneid-, Klemmverbindung zwischen einem Spulendrahtende und einer äusseren oder weiteren elektrischen Anschlussleitung hergestellt werden kann. Dieses mechanische Verbinden ist sehr einfach und schnell gegenüber einem Löten zum Verbinden von elektrischen Leitungen.

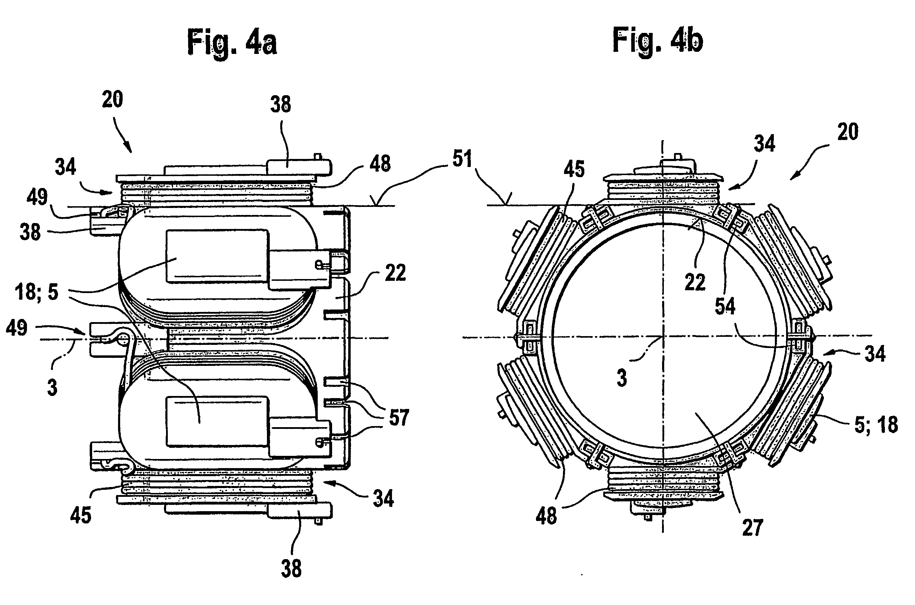

Figur 4 zeigt einen erfindungsgemässen Stator 20. Auf den Spulenkörper 34 ist eine Wicklung 45 gewickelt worden. Der Spulenkörper 34 hat eine unterste Wicklungsebene 51, die durch eine Linie gekennzeichnet ist, die der Mittelachse 3 am nächsten ist. Die unterste Wickelebene 51 berührt die Kunststoffbeschichtung 22 nur an dem einen jeweiligen Spulenkörper 34. So ist der Spulenkörper 34 zum Wickeln frei zugänglich und ein Wickelkopf einer Wicklungsmaschine kann frei um den Spulenkörper 34 kreisen.

Auf der Kunststoffbeschichtung 22 oder wie in diesem Ausführungsbeispiel hat der Spulenkörper 34 einen Wickelstützpunkt 54, der zum besseren Greifen des Blechlaminats 18 während des Wicklungsvorgangs dient. In diesem Beispiel dient die Aufnahme 38 als Wickelstützpunkt 54.
Ein Ende eines Spulendrahts 48 der Wicklung 45 ist in der Aufnahme 38 angeordnet und bspw. in einem Schlitz 49 eingeklemmt.

Figur 5 zeigt einen erfindungsgemässen Stator 20 gemäss Figur 5 mit einem Stanzgitter 60, das sich von einer Aufnahme 38 zu den anderen Aufnahmen 38 erstreckt und einen Sternpunkt der Wicklungen 45 bildet.

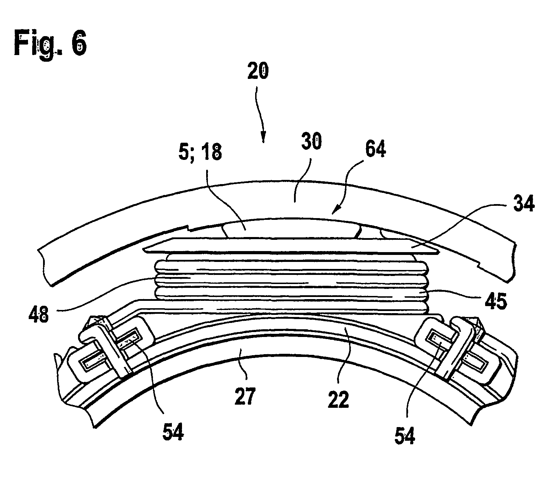

Figur 6 zeigt ein ringförmiges Aussenteil 30, das auf ein Blechlaminatstapel 16 oder ein Blechpaket 18 aufgeschoben werden kann. Dabei erstrecken sich die Vorsprünge 5 in radialer Richtung soweit, dass das Aussenteil mittels Kraftschluss auf dem Blechpaket gehalten wird. Dies erfolgt bspw. dadurch, dass der Vorsprung 5 gegenüber der Mittellinie 3 versetzt wird und sich das Aussenteil 30 so auf eine konische Flächen aufdrehen lässt.
Das Aussenteil 30 bildet bspw. ein magnetisches Rückschlusselement oder ein Motorgehäuseteil. Das Aussenteil 30 kann ebenfalls aus einzelnen Blechlaminaten gebildet sein.

## Patentansprüche

1. Stator (20) bestehend aus zumindest einem Blechlaminatstapel (16), der aus zumindest einem Blechlaminat (1) besteht, und einer zumindest teilweise vorhandenen Kunststoffbeschichtung (22), wobei der Stator (20) zumindest einen Kernring (70) hat, der einen wasserdichten Innenkanal (27) bildet und sich entlang einer Mittelachse (3) erstreckt, wobei auf den Kernring (70) zumindest ein Blechlaminatstapel (16) angeordnet ist und wobei der zumindest eine Blechlaminatstapel (16) durch die Kunststoffbeschichtung (22) zusammengehalten ist, **dadurch gekennzeichnet, dass** der Kernring (70) für jeden Blechlaminatstapel (16) zumindest einen hakenförmigen Vorsprung (77) hat, der auf einer Außenfläche des Kernrings (70) in Richtung der Mittelachse (3) des Stators (20) verläuft und dass der hakenförmige Vorsprung (77) den Blechlaminatstapel (16) zumindest teilweise umgreift und einen Formschluss bildet.

2. Stator nach Anspruch 1, **dadurch gekennzeichnet, dass** der Kernring ((70) zumindest eine Erhebung (74) hat, die auf einer Außenfläche des Kernrings (70) in Richtung der Mittelachse (3) verläuft und dass die Erhebung (74) in eine Nut (58) des Blechlaminatstapels (16) eingreift.

3. Stator nach Anspruch 1, **dadurch gekennzeichnet, dass** die Kunststoffbeschichtung (22) des Stators (20) durch Kunststoffspritzen hergestellt ist.

4. Stator nach Anspruch 1, **dadurch gekennzeichnet, dass** zumindest ein Blechlaminatstapel (16) zumindest einen sich radial nach außen erstreckenden Vorsprung (5) hat, auf dem eine elektrische Wicklung (45) angeordnet ist.

5. Stator nach Anspruch 4, **dadurch gekennzeichnet, dass** an zumindest einem Vorsprung (5) des Blechlaminats (1) ein Spulenkörper ((34) angespritzt ist.

6. Stator nach Anspruch 5, **dadurch gekennzeichnet, dass** die elektrische Wicklung (45) am Spulenkörper (34) angeordnet ist, dass die elektrische Wicklung (45) aus zumindest einem Spulendraht (48) besteht, und dass an der Kunststoffbeschichtung (22) zumindest eine Aufnahme (38) angeordnet ist, die zu einer Schneidklemmverbindung mit einem Spulendraht (48) dient.

7. Stator nach Anspruch 6, **dadurch gekennzeichnet, dass** an dem Spulenkörper (34) die zumindest eine Aufnahme (38) angeordnet ist.

8. Stator nach einem oder mehreren der Ansprüche 5 bis 7, **dadurch gekennzeichnet, dass** auf den Spulenkörper (34) eine Wicklung in zumindest einer Wickelebene gewickelt ist, dass es eine unterste Wickelebene (51) eines Spulenkörpers (34) gibt, die der Mittelachse (3) am nächsten ist, und dass die unterste Wickelebene (51) die Kunststoffbeschichtung (22) nur an dem jeweiligen Spulenkörper (34) berührt.

9. Stator nach einem oder mehreren der Ansprüche 5 bis 8, **dadurch gekennzeichnet, dass** der Spulenkörper (34) für einen Wickelvorgang des Spulenkörpers (34) mit einer Wicklung (45) zumindest einen Wickelstützpunkt (54) hat.

10. Stator nach einem oder beiden der Ansprüche 4 oder 5, **dadurch gekennzeichnet, dass** auf die Vorsprünge (5) des Blechlaminatstapels (18) ein Außenteil (30) aufgeschoben ist.

11. Stator nach Anspruch 10, **dadurch gekennzeichnet, dass** das Außenteil (30) aus einzelnen Blechschichten gebildet ist.

12. Stator nach einem oder mehreren der vorherigen Ansprüche, **dadurch gekennzeichnet, dass** der Blechlaminatstapel (18) ein Blechpaket (18) bildet.

## Claims

1. Stator (20) comprising at least one laminate stack (16), which comprises at least one laminate (1), and an at least partial plastic coating (22), the stator (20) having at least one core ring (70), which forms a water-tight inner channel (27) and extends along a central axis (3), at least one laminate stack (16) being arranged on the core ring (70), and the at least one laminate stack (16) being held together by the plastic coating (22), **characterized in that** the core ring (70) has, for each laminate stack (16), at least one projection (77) in the form of a hook, which runs on an outer surface of the core ring (70) in the direction of the central axis (3) of the stator (20), and **in that** the projection (77) in the form of a hook engages at least partially around the laminate stack (16) and forms an interlocking connection.

2. Stator according to Claim 1, **characterized in that** the core ring (70) has at least one elevation (74), which runs on an outer surface of the core ring (70) in the direction of the central axis (3), and **in that** the elevation (74) engages in a groove (58) in the laminate stack (16).

3. Stator according to Claim 1, **characterized in that** the plastic coating (22) of the stator (20) is produced by plastic injection moulding.

4. Stator according to Claim 1, **characterized in that** at least one laminate stack (16) has at least one projection (5), which extends radially outwards and on which is arranged an electrical winding (45).

5. Stator according to Claim 4, **characterized in that** a coil former (34) is injection moulded onto at least one projection (5) of the laminate (1).

6. Stator according to Claim 5, **characterized in that** the electrical winding (45) is arranged on the coil former (34), **in that** the electrical winding (45) comprises at least one coil wire (48), and **in that** at least one holder (38) is arranged on the plastic coating (22) and provides an insulation displacement connection with a coil wire (48).

7. Stator according to Claim 6, **characterized in that** the at least one holder (38) is arranged on the coil former (34).

8. Stator according to one or more of Claims 5 to 7, **characterized in that** a winding is wound onto the coil former (34) on at least one winding plane, **in that** there is a lowermost winding plane (51) of a coil former (34) which is closest to the central axis (3), and **in that** the lowermost winding plane (51) touches the plastic coating (22) only on the respective coil former (34).

9. Stator according to one or more of Claims 5 to 8, **characterized in that** the coil former (34) has at least one winding support point (54) for a winding step in which a winding (45) is wound onto the coil former (34).

10. Stator according to one or both of Claims 4 or 5, **characterized in that** an outer part (30) is pushed onto the projections (5) of the laminate stack (18).

11. Stator according to Claim 10, **characterized in that** the outer part (30) is formed from individual laminates.

12. Stator according to one or more of the preceding claims, **characterized in that** the laminate stack (18) forms a laminate core (18).

## Revendications

1. Stator (20) comprenant au moins une pile de tôles laminées (16), formée d'au moins une tôle laminée (1), et un revêtement du moins partiel en matière plastique (22), le stator (20) présentant au moins une bague de noyau (70) qui forme un canal intérieur (27) étanche à l'eau et s'étend le long d'un axe central (3), la pile de tôles laminées (16) étant disposée sur la bague de noyau (70) et maintenue par le revêtement en matière plastique (22),
**caractérisé en ce que**
pour chaque pile de tôles laminées (16), la bague de noyau (70) présente au moins une saillie (77) en forme de crochet qui s'étend sur une face extérieure de la bague de noyau (70) en direction de l'axe central (3) du stator (20), et entoure du moins partiellement la pile de tôles laminées (16) et assure une complémentarité de formes.

2. Stator selon la revendication 1,
**caractérisé en ce que**
la bague de noyau (70) présente au moins une élévation (74) qui s'étend sur une face extérieure de la bague de noyau (70) en direction de l'axe central (3), et s'engage dans une rainure (58) de la pile de tôles laminées (16).

3. Stator selon la revendication 1,
**caractérisé en ce que**
le revêtement en matière plastique (22) du stator (20) est réalisé par injection de matière plastique.

4. Stator selon la revendication 1,
**caractérisé en ce qu'**
au moins une pile de tôles laminées (16) présente au moins une saillie (5) s'étendant radialement vers l'extérieur sur laquelle est disposé un bobinage électrique (45).

5. Stator selon la revendication 4,
**caractérisé en ce qu'**
un corps de bobine (34) est rapporté par injection sur au moins une saillie (5) de la tôle laminée (1)

6. Stator selon la revendication 5,
**caractérisé en ce que**
le bobinage électrique (45) disposé sur le corps de bobine (34), comprend au moins un fil à bobiner (48), et sur le revêtement en matière plastique (22) est disposé au moins un logement (38) qui sert de raccord à serrage avec un fil à bobiner (48).

7. Stator selon la revendication 6,
**caractérisé en ce qu'**
au moins un logement (38) est disposé sur le corps de bobine (34).

8. Stator selon l'une ou plusieurs des revendications 5 à 7,
**caractérisé en ce qu'**
un bobinage est enroulé sur le corps de bobine (34) dans au moins un plan d'enroulement, et un plan d'enroulement inférieur (51) d'un corps de bobine (34) est le plus rapproché de l'axe central (3), et ce plan d'enroulement inférieur (51) ne touche le revêtement en matière plastique (22) qu'au niveau du corps de bobine (34) respectif.

9. Stator selon l'une ou plusieurs des revendications 5 à 8,
**caractérisé en ce que**
le corps de bobine (34) présente au moins un point d'appui d'enroulement (54) pour une opération d'enroulement du corps de bobine (34) avec un bobinage (45).

10. Stator selon l'une ou plusieurs des revendications 4 ou 5,
**caractérisé en ce qu'**
un élément extérieur (30) est glissé sur les saillies (5) de la pile de tôles laminées (18).

11. Stator selon la revendication 10,
**caractérisé en ce que**
l'élément extérieur (30) est formé de couches de tôle indépendantes.

12. Stator selon l'une ou plusieurs des revendications précédentes,
**caractérisé en ce que**
la pile de tôles laminées (18) forme un paquet de tôles (18).
